# EUROPEAN PATENT SPECIFICATION

(11) **EP 2 685 513 B1**
(45) Date of publication and mention of the grant of the patent: **21.10.2015**
(21) Application number: 12755243.8
(22) Date of filing: 23.02.2012
(51) Int. Cl.: H01L 33/62, C09J 9/02, H01L 21/60, H01L 33/60

(54) **LIGHT-REFLECTIVE ANISOTROPIC CONDUCTIVE ADHESIVE AND LIGHT-EMITTING DEVICE**
LICHTREFLEKTIERENDES, ANISOTROPISCH LEITFÄHIGES HAFTMITTEL UND LICHTEMITTIERENDE VORRICHTUNG
ADHÉSIF CONDUCTEUR ANISOTROPE RÉFLÉCHISSANT LA LUMIÈRE ET DISPOSITIF ÉLECTROLUMINESCENT

(30) Priority: 07.03.2011 JP 2011048625
(43) Date of publication of application: 15.01.2014
(73) Proprietor: Dexerials Corporation, Tokyo 141-0032 (JP)
(72) Inventor: NAMIKI Hidetsugu, Tochigi 322-8503 (JP); KANISAWA Shiyuki, Tochigi 322-8503 (JP); UMAKOSHI Hideaki, Tochigi 322-8503 (JP); ISHIGAMI Akira, Tochigi 322-8503 (JP)
(74) Representative: Müller-Boré & Partner Patentanwälte PartG mbB
(86) International application number: PCT/JP2012/054411
(87) International publication number: WO 2012/121021

(56) References cited:
- EP-A1- 1 279 720
- WO-A1-2010/098273
- JP-A- 11 343 465
- JP-A- 2001 332 124
- JP-A- 2008 192 880
- JP-A- 2010 225 597

## Description

### Technical Field

The present invention relates to a light-reflective anisotropic conductive adhesive used for anisotropic conductive connection of a light-emitting element to a wiring board and also relates to a light-emitting device produced by mounting a light-emitting element on a wiring board using the adhesive.

### Background Art

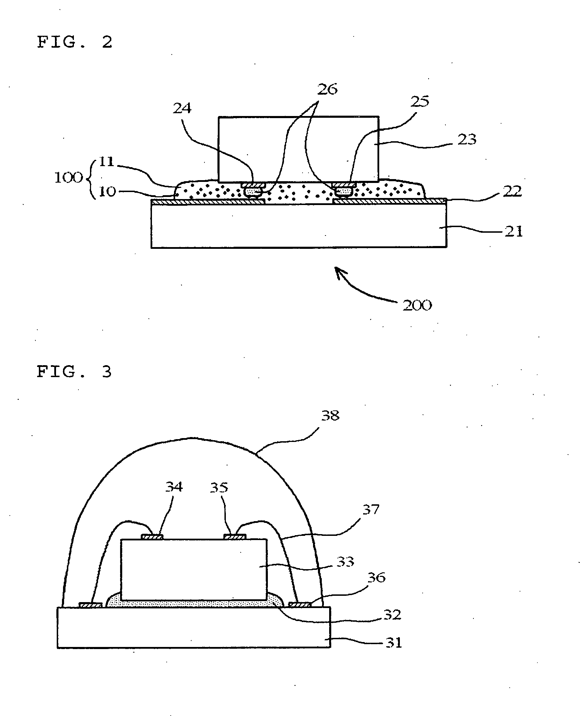

Light-emitting devices using light-emitting diode (LED) elements are being widely used. An old-type light-emitting device has a structure shown in FIG. 3. More specifically, an LED element 33 is bonded to a substrate 31 with a die-bonding adhesive 32, and a p electrode 34 and an n electrode 35 on the upper surface of the LED element 33 are wire-bonded to connection terminals 36 of the substrate 31 with gold wires 37. The entire LED element 33 is sealed with a transparent molding resin 38. Incidentally, in the light-emitting device shown in FIG. 3, light having a wavelength of 400 to 500 nm and emitted upward from the LED element 33 is absorbed by the gold wires, and part of the light emitted downward is absorbed by the die-bonding adhesive 32. Therefore, there is a problem in that the light emission efficiency of the LED element 33 is reduced.

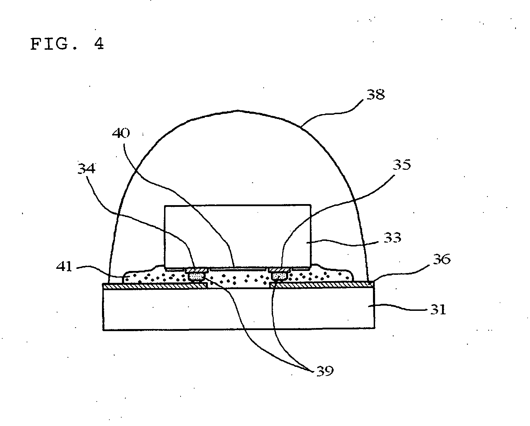

In view of the above, as shown in FIG. 4, flip-chip mounting of an LED element 33 has been proposed (Patent Literature 1). In this flip-chip mounting technology, bumps 39 are formed on a p electrode 34 and an n electrode 35, respectively, and a light reflecting layer 40 is provided on the bump-formed surface of the LED element 33 so that the p electrode 34 and the n electrode 35 are insulated from each other. The LED element 33 and a substrate 31 are connected to each other using an anisotropic conductive film (ACF) (not shown) or an anisotropic conductive paste (ACP) 41 in which an epoxy resin is used as a binder resin and are fixed to each other by curing the ACF or the ACP 41. Therefore, in the light-emitting device in FIG. 4, the light emitted upward from the LED element 33 is not absorbed by gold wires, and almost all the light emitted downward is reflected by the light reflecting layer 40 and then emitted upward. Therefore, light emission efficiency (light extraction efficiency) is not reduced.

### Citation List

### Patent Literature

[Patent Literature 1] Japanese Patent Application Laid-Open No. Hei. 11-168235

### Summary of Invention

### Problem(s) to be solved by the Invention

However, in the technology of Patent Literature 1, the light reflecting layer 40 must be provided on the LED element 33 by a metal vapor deposition method or the like so that the p electrode 34 and the n electrode 35 are insulated from each other, and therefore, there is a problem in that an increase in production cost is unavoidable.

When no light reflecting layer 40 is provided, the surfaces of gold-, nickel-, or copper-coated conductive particles contained in the cured ACP or ACF assume a brown or dark brown color. Furthermore, the epoxy resin binder containing the conductive particles dispersed therein also assumes a brown color due to an imidazole-based latent curing agent commonly used to cure the binder. Therefore, there is a problem in that it is difficult to improve the light emission efficiency (light extraction efficiency) of light emitted from the light-emitting element.

In addition to the above-described problems (the problem of an increase in cost and the problem of light extraction efficiency), there are more serious problems which are the occurrence of cracks in the anisotropic conductive connection portion and a reduction in conduction reliability. More specifically, in the light-emitting device obtained by anisotropic conductive connection of the LED element 33 and the substrate 31 with the ACP or the ACF, the epoxy resin used as the binder resin for the ACP or the ACF has a linear thermal expansion coefficient higher than that of the substrate 31. Therefore, internal stress occurs in the cured ACP or ACF adhering to the substrate when the temperature of the surroundings of the light-emitting device changes (for example, when the temperature of the light-emitting device changes during reflow processing for lead-free solder, a thermal shock test, use and storage in a high-temperature atmosphere, and the like). This causes a problem in that cracks occur in the anisotropic conductive connection portion and a problem in that conduction reliability is reduced.

It is an object of the present invention to solve the foregoing problems in the conventional technology. More specifically, it is an object to improve the light emission efficiency of a light-emitting device produced by flip-chip mounting a light-emitting element such as a light-emitting diode (LED) element on a wiring board using an anisotropic conductive adhesive, without providing, on the LED element, a light reflecting layer that causes an increase in production cost. Another object is to suppress or prevent a reduction in conduction reliability and the occurrence of cracks that occur in the anisotropic conductive connection portion of the light-emitting device when the temperature of the surroundings thereof changes. Means for Solving the Problem(s)

Under the assumption that a reduction in light emission efficiency can be prevented when the anisotropic conductive adhesive itself has a light-reflecting function, the present inventors have found the following: (a) the reduction in the light emission efficiency of the light-emitting element can be prevented by adding light-reflective insulating particles to the anisotropic conductive adhesive; (b) in this case, spherical light-reflective insulating particles provide a higher ability to prevent the reduction in light emission efficiency than needle-shaped light-reflective insulating particles; (c) on the other hand, the needle-shaped light-reflective insulating particles are more effective to suppress a reduction in conduction reliability and the occurrence of cracks in the anisotropic conduction connection portion than the spherical light-reflective insulating particles; (d) therefore, to achieve the improvement in light emission efficiency of the light-emitting element, the suppression or prevention of the reduction in conduction reliability, and the suppression or prevention of the occurrence of cracks simultaneously, the light-reflective needle-shaped insulating particles and the light-reflective spherical insulating particles should be added in a specific ratio. Thus, the present invention has been completed.

Accordingly, the present invention provides a light-reflective anisotropic conductive adhesive used for anisotropic conductive connection of a light-emitting element to a wiring board. The light-reflective anisotropic conductive adhesive contains a thermosetting resin composition, conductive particles, light-reflective needle-shaped insulating particles, and light-reflective spherical insulating particles. In the thermosetting resin composition, each of the amount of the light-reflective needle-shaped insulating particles and the amount of the light-reflective spherical insulating particles is 1 to 50 percent by volume based on the volume of the thermosetting resin composition, and the mixing ratio (V/V) of the light-reflective spherical insulating particles to the light-reflective needle-shaped insulating particles is 1:1 to 10.

The present invention also provides a light-emitting device in which a light-emitting element is flip-chip mounted on a wiring board through the light-reflective anisotropic conductive adhesive.

### Advantageous Effects of Invention

In the light-reflective anisotropic conductive adhesive of the present invention, each of the amount of the light-reflective needle-shaped insulating particles and the amount of the light-reflective spherical insulating particles is 1 to 50 percent by volume based on the volume of the thermosetting resin composition. In addition, the mixing ratio (V/V) of the light-reflective spherical insulating particles to the light-reflective needle-shaped insulating particles is set to 1:1 to 10. Therefore, light emission efficiency can be improved without providing, on the LED element, a light reflecting layer that causes an increase in production cost. In addition, a reduction in conduction reliability and the occurrence of cracks in the anisotropic conductive connection portion of the light-emitting device when the temperature of the surroundings thereof changes can be suppressed or prevented.

### Brief Description of Drawings

FIG. 1A is a cross-sectional view of a light-reflective conductive particle used for a light-reflective anisotropic conductive adhesive of the present invention.
FIG. 1B is a cross-sectional view of a light-reflective conductive particle used for the light-reflective anisotropic conductive adhesive of the present invention.
FIG. 2 is a cross-sectional view of a light-emitting device of the present invention.
FIG. 3 is a cross-sectional view of a conventional light-emitting device.
FIG. 4 is a cross-sectional view of a conventional light-emitting device.

### Description of Embodiments

The light-reflective anisotropic conductive adhesive of the present invention is used for anisotropic conductive connection of a light-emitting element to a wiring board and contains a thermosetting resin composition, conductive particles, light-reflective needle-shaped insulating particles, and light-reflective spherical insulating particles.

The reason that the light-reflective needle-shaped insulating particles and also the light-reflective spherical insulating particles are used in the present invention as light-reflective insulating particles is as follows.

Generally, when a thermosetting resin composition contains light-reflective insulating particles, the elasticity of the resin composition decreases (the resin composition becomes harder) as temperature changes. Then cracks are more likely to occur at the boundaries between the light-reflective insulating particles and the thermosetting resin composition due to the internal stress of the thermosetting resin composition (or its cured product). When cracks occur in the light-reflective anisotropic conductive adhesive, conduction reliability deteriorates. Therefore, the light-reflective anisotropic conductive adhesive must have high toughness. When light-reflective needle-shaped insulating particles are added as light-reflective insulating particles to the thermosetting resin composition, high toughness can be imparted to the light-reflective anisotropic conductive adhesive. This is because of the following reason. The light-reflective needle-shaped insulating particles are distributed in random directions in the thermosetting resin composition. These light-reflective needle-shaped insulating particles are flexible and easily bent, and therefore the internal stress in the thermosetting resin composition caused by temperature change can propagate to the needle-shaped crystals and can be absorbed thereby. This can suppress the propagation of the internal stress to the thermosetting resin composition. Therefore, such a light-reflective anisotropic conductive adhesive containing the light-reflective needle-shaped insulating particles has superior toughness, can suppress or prevent the occurrence of cracks even when the thermosetting resin composition expands and contracts because of temperature change, and can suppress or prevent a reduction in conduction reliability.

On the other hand, when only light-reflective needle-shaped insulating particles are used as the light-reflective insulating particles, light reflectivity tends to decrease. Therefore, in the present invention, light-reflective spherical insulating particles having favorable light reflecting property are used together with the light-reflective needle-shaped insulating particles.

The amount of such light-reflective needle-shaped insulating particles added to the thermosetting resin composition is 1 to 50 percent by volume based on the volume of the thermosetting resin composition, and preferably 5 to 25 percent by volume. This is because, if the amount added of the light-reflective needle-shaped insulating particles is less than 1 percent by volume, it tends to be difficult to sufficiently suppress or prevent a reduction in conduction reliability and the occurrence of cracks in the connection portion formed of the light-reflective anisotropic conductive adhesive. If the amount added is too large, the relative amount added of the thermosetting resin composition becomes low, and this causes a reduction in the adhesion of the light-reflective anisotropic conductive adhesive. In this case, the amount added of the light-reflective spherical insulating particles also becomes low, and an improvement in the light reflectivity of the connection portion formed of the light-reflective anisotropic conductive adhesive tends to be insufficient. Therefore, in the above range, the effects of the present invention can be obtained.

The amount of the light-reflective spherical insulating particles added to the thermosetting resin composition is 1 to 50 percent by volume based on the volume of the thermosetting resin composition, and preferably 2 to 25 percent by volume. This is because, if the amount added of the light-reflective spherical insulating particles is less than 1 percent by volume, an improvement in light reflectivity of the connection portion formed of the light-reflective anisotropic conductive adhesive tends to be insufficient. If the amount is too large, the relative amount added of the thermosetting resin composition becomes low, and this causes a reduction in the adhesion of the light-reflective anisotropic conductive adhesive. In addition, the relative amount added of the light-reflective needle-shaped insulating particles becomes low, and it tends to be difficult to suppress the occurrence of cracks in the connection portion formed of the light-reflective anisotropic conductive adhesive and also difficult to improve a reduction in conduction reliability. Therefore, in the above range, the effects of the present invention can be obtained.

The mixing ratio (V/V) of the light-reflective spherical insulating particles to the light-reflective needle-shaped insulating particles is 1:1 to 10 and preferably 1:2 to 8. This is because, if the relative amount of the light-reflective spherical insulating particles is out of the above range and is smaller than the relative amount of the light-reflective needle-shaped insulating particles, light reflection property tends to deteriorate. If the relative amount is larger, anti-cracking property tends to deteriorate.

Preferably, a needle-shaped inorganic compound that assumes a white color is used for the light-reflective needle-shaped insulating particles when they are applied to a light-emitting device that emits visible light. Such light-reflective needle-shaped insulating particles reflect light incident on the light-reflective anisotropic conductive adhesive to the outside, and the light-reflective needle-shaped insulating particles themselves assume a white color. Therefore, the wavelength dependency of light reflection property with respect to visible light can be reduced, and visible light can be efficiently reflected.

The diameter of the light-reflective needle-shaped insulating particles is preferably 5 µm or lower. The aspect ratio of the light-reflective needle-shaped insulating particles is preferably larger than 10 so that they can propagate and absorb the internal stress of the thermosetting resin composition sufficiently. The aspect ratio is preferably less than 35 so that the light-reflective needle-shaped insulating particles are hard to bend and can be uniformly dispersed in the thermosetting resin composition. To further improve the dispersibility in the thermosetting resin composition, the aspect ratio is more preferably less than 20.

Preferred specific examples of such light-reflective needle-shaped insulating particles include white needle-shaped inorganic particles such as zinc oxide whiskers, titanium oxide whiskers, titanate whiskers, e.g., potassium titanate whiskers and sodium titanate whiskers, aluminum borate whiskers, and wollastonite (needle-shaped crystals of kaolin silicate). One type or two or more types of such particles may be used. Whiskers are crystals grown into a needle shape by a special production method. Since only few irregularities are present in their crystal structure, their advantages are high elasticity and high resistance to deformation. The above inorganic compounds assume a white color in the light-emitting device that emits visible light. Therefore, they have low wavelength dependency of light reflection property with respect to the visible light and can easily reflect the visible light. Of the above inorganic compounds, zinc oxide whiskers are particularly preferred because they have high whiteness and do not exhibit catalytic activity on photodegradation even when there is a fear of photodegradation of the cured product of the thermosetting resin composition in the cured anisotropic conductive adhesive.

Instead of such single-needle-shaped crystals, for example, crystals having a multi-needle shape (multi-needle-shaped crystals) such as a tetrapod (registered trademark) shape formed by connecting the apexes of a tetrahedron to its center may be used as the light-reflective needle-shaped insulating particles. White needle-shaped inorganic particles of multi-needle-shaped crystals are superior to white needle-shaped inorganic particles of single-needle-shaped crystals in that thermal conductivity is higher. However, the crystal structure of the multi-needle-shaped crystals is more bulky than that of the single-needle-shaped crystals. Therefore, it is necessary to pay attention not to damage the substrate and the connecting members of the element by the needle portions during thermocompression bonding.

These light-reflective needle-shaped insulating particles may be treated with, for example, a silane coupling agent. When the inorganic particles are treated with a silane coupling agent, the dispersibility of the inorganic particles in the thermosetting resin composition can be improved. Therefore, the needle-shaped inorganic particles, preferably light-reflective needle-shaped insulating particles obtained by treating zinc oxide whiskers with a silane coupling agent, can be uniformly mixed with the thermosetting resin composition in a short time.

Preferably, the refractive index (JIS K7142) of the light-reflective needle-shaped insulating particles is larger than the refractive index (JIS K7142) of the cured product of the thermosetting resin composition and more preferably is larger by at least about 0.02. This is because, when the difference in refractive index is small, the light reflective efficiency at the interface therebetween becomes low.

Preferably, in the light-reflective anisotropic conductive adhesive, a spherical inorganic compound that assumes a white color is used for the light-reflective spherical insulating particles used together with the light-reflective needle-shaped insulating particles when these particles are applied to a light-emitting device that emits visible light. Such light-reflective spherical insulating particles reflect light incident on the light-reflective anisotropic conductive adhesive to the outside, and the light-reflective spherical insulating particles themselves assume a white color. Therefore, the wavelength dependency of light reflection property with respect to visible light can be reduced, and visible light can be efficiently reflected.

The average diameter of the light-reflective spherical insulating particles is preferably 0.02 to 20 µm and more preferably 0.2 to 1 µm. This is because, if the average diameter is too small, the light reflectivity of the cured product of the light-reflective anisotropic conductive adhesive becomes low and because, if the average diameter is too large, the anisotropic conductive connection by the conductive particles tends to be inhibited.

Preferred specific examples of the light-reflective spherical insulating particles include at least one type of inorganic particles selected from the group consisting of titanium oxide (TiO₂) particles, boron nitride (BN) particles, zinc oxide (ZnO) particles, and aluminum oxide (Al₂O₃) particles. Of these, TiO₂ is preferably used because of its high refractive index. If necessary, a coating layer of Si and Al may be formed on the surfaces of these particles by a routine method.

Preferably, the refractive index (JIS K7142) of the light-reflective spherical insulating particles is larger than the refractive index (JIS K7142) of the cured product of the thermosetting resin composition and more preferably is larger by at least about 0.02. This is because, when the difference in refractive index is small, the light reflective efficiency at the interface therebetween becomes low.

The light-reflective spherical insulating particles used may be resin-coated metal particles obtained by coating the surfaces of spherical metal particles with a transparent insulating resin. Examples of the metal material of the spherical metal particles include nickel, silver, and aluminum. Of these, silver is preferably used.

The preferred average diameter of the resin-coated metal particles used as the light-reflective spherical insulating particles depends on their shape. Generally, if the average diameter is too large, the anisotropic conductive connection by the conductive particles may be inhibited. If the average diameter is too small, light is less likely to be reflected. Therefore, the average diameter is preferably 0.1 to 30 µm and more preferably 0.2 to 10 µm. The average diameter of the resin-coated metal particles is a diameter including the thickness of the insulating coating.

Any of various insulating resins can be used as the resin for the resin-coated metal particles used as the light-reflective spherical insulating particles. In terms of mechanical strength, transparency, and the like, the cured product of an acrylic-based resin can be preferably used. Preferred examples of such a resin include a resin obtained by radical copolymerization of methyl methacrylate and 2-hydroxyethyl methacrylate in the presence of a radical polymerization initiator such as an organic peroxide, e.g., benzoyl peroxide. In this case, it is more preferable that the cured product be crosslinked by an isocyanate-based cross-linking agent such as 2,4-tolylenediisocyanate. Preferably, γ-glycidoxy groups, vinyl groups, and the like are introduced in advance to the surfaces of the metal particles using a silane coupling agent.

Such resin-coated metal particles can be produced, for example, by adding metal particles and a silane coupling agent to a solvent such as toluene, stirring the mixture at room temperature for about 1 hour, adding thereto a radical monomer, a radical polymerization initiator, and, if necessary, a cross-linking agent, and stirring the resultant mixture under heating at the starting temperature of radical polymerization.

Metal particles conventionally used as conductive particles for anisotropic conductive connection can be used as the conductive particles constituting the light-reflective anisotropic conductive adhesive of the present invention. Examples of such particles include gold, nickel, copper, silver, solder, palladium, and aluminum particles, particles of alloys thereof, and particles of a layered product thereof (for example, a layered product including nickel plating and gold flash plating). Of these, gold, nickel, and copper make the conductive particles brown and therefore can enjoy the effects of the present invention more than other metal materials.

Metal-coated resin particles obtained by coating resin particles with a metal material may also be used as the conductive particles. Examples of such resin particles include styrene-based resin particles, benzoguanamine resin particles, and nylon resin particles. Any well-known method can be used to coat the resin particles with the metal material. For example, electroless plating or electroplating can be used. The thickness of the coating metal material depends on the diameter of the resin particles and the type of the metal, and the thickness sufficient to ensure favorable conduction reliability is generally 0.1 to 3 µm.

If the average diameter of the resin particles is too small, conduction failure tends to occur. If the average diameter is too large, a short circuit between traces tends to occur. Therefore, the average diameter of the resin particles is preferably 1 to 20 µm, more preferably 3 to 10 µm, and particularly preferably 3 to 5 µm. In this case, the shape of core particles 1 is preferably spherical but may be a flake-like shape or a rugby ball shape.

Preferred metal-coated resin particles have a spherical shape. If the diameter of the particles is too large, a reduction in conduction reliability occurs. Therefore, the diameter is preferably 1 to 20 µm and more preferably 3 to 10 µm.

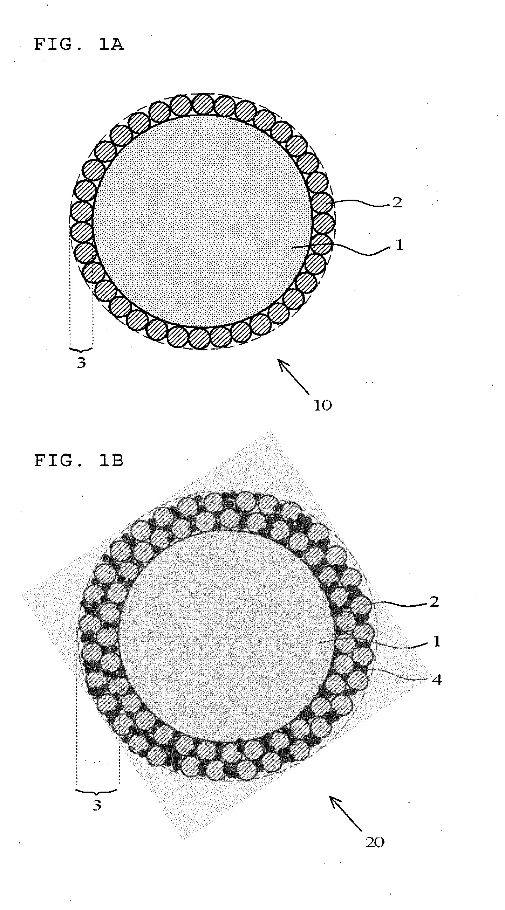

Particularly, in the present invention, it is preferable to impart light reflectivity to the above-described conductive particles to form light-reflective conductive particles. FIGs. 1A and 1B are cross-sectional views of light-reflective conductive particles 10 and 20. The light-reflective conductive particle shown in FIG. 1A will first be described.

The light-reflective conductive particle 10 includes a core particle 1 coated with a metal material and a light reflecting layer 3 disposed on the surface of the core particle 1 and formed of at least one type of inorganic particles 2 selected from titanium oxide (TiO₂) particles, zinc oxide (ZnO) particles, and aluminum oxide (Al₂O₃) particles. The titanium oxide particles, zinc oxide particles, and aluminum oxide particles are inorganic particles that assume a white color under sunlight. Therefore, the light reflecting layer 3 formed of such particles assumes a white to gray color. The white to gray color means that the wavelength dependency of light reflection property with respect to visible light is small and visible light is easily reflected.

Among the titanium oxide particles, zinc oxide particles, and aluminum oxide particles, the zinc oxide particles have a high refractive index and no catalytic activity on photodegradation and therefore can be preferably used when there is a fear of photodegradation of the cured product of the thermosetting resin composition in the cured anisotropic conductive adhesive.

The core particle 1 is used for anisotropic conductive connection, and the surface thereof is formed of a metal material. Examples of the form of the surface coated with a metal material include the form in which the core particle 1 itself is formed of the metal material and the form in which the surface of a resin particle is coated with the metal material, as described above.

If the thickness of the light reflecting layer 3 formed of the inorganic particles 2 is too small relative to the diameter of the core particle 1, a significant reduction in reflectivity occurs. If the thickness is too large, conduction failure occurs. Therefore, the thickness of the light reflecting layer 3 is preferably 0.5 to 50% of to the diameter of the core particle 1 and more preferably 1 to 25%.

In the light-reflective conductive particle 10, if the diameter of the inorganic particles 2 constituting the light reflecting layer 3 is too small, a light-reflection phenomenon is less likely to occur. If the diameter is too large, it tends to be difficult to form the light reflecting layer 3. Therefore, the diameter of the inorganic particles 2 is preferably 0.02 to 4 µm, more preferably 0.1 to 1 µm, and particularly preferably 0.2 to 0.5 µm. In this case, from the viewpoint of the wavelength of light to be reflected (i.e., the light emitted from the light-emitting element), the diameter of the inorganic particles 2 is preferably equal to or larger than 50% of the wavelength of the light to be reflected so that the light is not transmitted. In this case, examples of the shape of the inorganic particles 2 include an irregular shape, a spherical shape, a scale-like shape, and a needle-like shape. Of these, a spherical shape is preferred in terms of light diffusion effects, and a scale-like shape is preferred in terms of total reflection effects.

The light-reflective conductive particles 10 as shown in FIG. 1A can be produced by a well-known film deposition technique (a so-called mechano-fusion method) in which a large-size powder and a small-size powder are brought into physical collision to form a film composed of the small-diameter particles on the surfaces of the large-diameter particles. In this case, the inorganic particles 2 bite into and are secured to the metal material on the surfaces of the core particles 1. Since the inorganic particles 2 are less likely to be fused to each other, a mono-layer of the inorganic particles forms the light reflecting layer 3. Therefore, in the case of FIG. 1A, the thickness of the light reflecting layer 3 may be equivalent to or slightly smaller than the diameter of the inorganic particles 2.

The light-reflective conductive particle 20 shown in FIG. 1B will next be described. The light-reflective conductive particle 20 is different from the light-reflective conductive particle 10 in FIG. 1A in that the light reflecting layer 3 contains a thermoplastic resin 4 serving as an adhesive and that the inorganic particles 2 are secured to each other with the thermoplastic resin 4 and form multiple layers (for example, two or three layers). Since such a thermoplastic resin 4 is contained, the mechanical strength of the light reflecting layer 3 is improved, so that, for example, exfoliation of the inorganic particles 2 is less likely to occur.

To reduce the load on the environment, a halogen-free thermoplastic resin can be preferably used as the thermoplastic resin 4. For example, polyolefin such as polyethylene or polypropylene, polystyrene, or an acrylic resin can be preferably used.

The light-reflective conductive particles 20 can also be produced by the mechano-fusion method. If the particle diameter of the thermoplastic resin 4 used in the mechano-fusion method is too small, its bonding function becomes low. If the diameter is too large, the thermoplastic resin 4 is less likely to adhere to the core particles 1. Therefore, the particle diameter of the thermoplastic resin 4 is preferably 0.02 to 4 µm and more preferably 0.1 to 1 µm. If the amount added of the thermoplastic resin 4 is too small, its bonding function becomes low. If the amount is too large, aggregates of the light-reflective conductive particles and the core particles are formed. Therefore, the amount added of the thermoplastic resin 4 is preferably 0.2 to 500 parts by mass based on 100 parts by mass of the inorganic particles 2 and more preferably 4 to 25 parts by mass.

Preferably, the thermosetting resin composition used in the light-reflective anisotropic conductive adhesive of the present invention is as colorless and transparent as possible. This is to prevent a reduction in the light reflective efficiency of the light-reflective insulating particles in the light-reflective anisotropic conductive adhesive and to allow incident light to be reflected without any change in the color of the incident light. The colorless and transparent herein means that the light transmittance (JIS K7150) of the cured product of the thermosetting resin composition with respect to visible light having a wavelength of 380 to 780 nm with a light path length of 1 cm is 80% or higher and preferably 90% or higher.

In the light-reflective anisotropic conductive adhesive of the present invention, if the amount added of the conductive particles such as the light-reflective conductive particles is too small, conduction failure tends to occur. If the amount is too large, short circuits between traces tend to occur. Therefore, the amount added of the conductive particles is preferably 1 to 100 parts by mass based on 100 parts by mass of the thermosetting resin composition and more preferably 10 to 50 parts by mass.

Preferably, the light-reflective anisotropic conductive adhesive of the present invention has the light reflection property that can improve the light emission efficiency of a light-emitting element. More specifically, the cured product of the light-reflective anisotropic conductive adhesive has a reflectivity (JIS K7105) with respect to light having a wavelength of 450 nm of preferably at least 30%. To achieve such a light reflectivity, the light reflection property and amount added of the light-reflective conductive particles used and the mixed composition of the thermosetting resin composition, and the like may be appropriately adjusted. Generally, as the amount added of light-reflective conductive particles having the favorable light reflection property increases, the reflectivity tends to increase.

The light reflection property of the light-reflective anisotropic conductive adhesive can be evaluated also from its refractive index. This is because, if the refractive index of the cured product of the adhesive is higher than the refractive index of the cured product of the thermosetting resin composition excluding the conductive particles, the light-reflective needle-shaped insulating particles, and the light-reflective spherical insulating particles, the amount of light reflected by the interface between the light-reflective needle-shaped insulating particles and the light-reflective spherical insulating particles and the cured product of the surrounding thermosetting resin composition increases. More specifically, the differences obtained by subtracting the refractive index (JIS K7142) of the cured product of the thermosetting resin composition from the refractive indexes (JIS K7142) of the light-reflective needle-shaped insulating particles and the light-reflective spherical insulating particles are preferably 0.02 or larger and more preferably 0.2 or larger. Generally, the refractive index of a thermosetting resin composition composed mainly of an epoxy resin is about 1.5.

Any thermosetting resin composition used for conventional anisotropic conductive adhesives and anisotropic conductive films can be used as the thermosetting resin composition constituting the light-reflective anisotropic conductive adhesive of the present invention. Generally, such a thermosetting resin composition is prepared by adding a curing agent to an insulating binder resin. Preferred examples of the insulating binder resin include epoxy-based resins composed mainly of an alicyclic epoxy compound, a heterocyclic epoxy compound, a hydrogenated epoxy compound, and the like.

Preferred examples of the alicyclic epoxy compound include compounds having at least two epoxy groups in their molecules. These may be a liquid form or a solid form. Specific examples of the alicyclic epoxy compound include glycidylhexahydrobisphenol A and 3,4-epoxycyclohexenylmethyl-3,4'-epoxycyclohexene carboxylate. Of these, glycidylhexahydrobisphenol A and 3,4-epoxycyclohexenylmethyl-3',4'-epoxycyclohexene carboxylate can be preferably used because they have fast curability and their cured products have light transmittance suitable for, for example, mounting of LED elements.

Examples of the heterocyclic epoxy compound include epoxy compounds having a triazine ring, and particularly preferred examples include 1,3,5-tris(2,3-epoxypropyl)-1,3,5-triazine-2,4,6-(1H,3H,5H)-trione.

Any of hydrogenated products of the above-described alicyclic epoxy compounds and heterocyclic epoxy compounds and other well-known hydrogenated epoxy resins can be used as the hydrogenated epoxy compound.

The alicyclic epoxy compounds, the heterocyclic epoxy compounds, and the hydrogenated epoxy compounds may be used alone or in combination of two or more types. Other epoxy compounds may also be used in addition to these epoxy compounds, so long as the effects of the present invention are not impaired. Examples of such epoxy compounds include well-known epoxy resins such as: glycidyl ethers obtained by reacting epichlorohydrin with a polyphenol such as bisphenol A, bisphenol F, bisphenol S, tetramethyl bisphenol A, diallyl bisphenol A, hydroquinone, catechol, resorcin, cresol, tetrabromo bisphenol A, trihydroxybiphenyl, benzophenone, bisresorcinol, bisphenolhexafluoroacetone, tetramethyl bisphenol A, tetramethyl bisphenol F, tris(hydroxyphenyl)methane, bixylenol, phenol novolac, or cresol novolac; polyglycidyl ethers obtained by reacting epichlorohydrin with an aliphatic polyalcohol such as glycerin, neopentyl glycol, ethylene glycol, propylene glycol, butylene glycol, hexylene glycol, polyethylene glycol, or polypropylene glycol; glycidyl ether esters obtained by reacting epichlorohydrin with a hydroxy carboxylic acid such as p-oxybenzoic acid or β-oxynaphthoic acid; polyglycidyl esters obtained from polycarboxylic acids such as phthalic acid, methylphthalic acid, isophthalic acid, terephthalic acid, tetrahydrophthalic acid, endomethylene tetrahydrophthalic acid, endomethylene hexahydrophthalic acid, trimellitic acid, and polymerized fatty acids; glycidylaminoglycidyl ethers obtained from aminophenols and aminoalkylphenols; glycidylaminoglycidyl esters obtained from amino benzoic acids; glycidylamines obtained from aniline, toluidine, tribromoaniline, xylylenediamine, diaminocyclohexane, bisaminomethylcyclohexane, 4,4'-diaminodiphenylmethane, 4,4'-diaminodiphenylsulfone, and the like; and epoxidized polyolefins.

Examples of the curing agent include acid anhydrides, imidazole compounds, and dicyan. Of these, acid anhydride-based curing agents that are less likely to discolor a cured product, particularly alicyclic acid anhydride-based curing agents, can be preferably used. Specific examples of such a curing agent include methylhexahydrophthalic anhydride.

When an alicyclic epoxy compound and an alicyclic acid anhydride-based curing agent are used for the thermosetting resin composition in the light-reflective anisotropic conductive adhesive of the present invention, if the amount used of the alicyclic acid anhydride-based curing agent is too small, the amount of the uncured epoxy compound tends to be large. If the amount used is too large, the corrosion of a material to be adhered tends to be facilitated by the effects of the excess curing agent. Therefore, the alicyclic acid anhydride-based curing agent is used in an amount of preferably 80 to 120 parts by mass based on 100 parts by mass of the alicyclic epoxy compound and more preferably 95 to 105 parts by mass.

The light-reflective anisotropic conductive adhesive of the present invention can be produced by uniformly mixing the light-reflective needle-shaped insulating particles, the light-reflective spherical insulating particles, the conductive particles, and the thermosetting resin composition. When the light-reflective anisotropic conductive adhesive of the present invention is formed into a light-reflective anisotropic conductive film, the light-reflective needle-shaped insulating particles, the light-reflective spherical insulating particles, the conductive particles, the thermosetting resin composition, and a solvent such as toluene are mixed to disperse these particles and the thermosetting resin composition in the solvent, and the dispersion is applied to a release-treated PET film to a prescribed thickness and dried at a temperature of about 80°C.

A light-emitting device of the present invention will next be described with reference to FIG. 2. The light-emitting device 200 includes a substrate 21 and an LED element 23 that is used as a light-emitting element and flip-chip mounted thereon through the light-reflective anisotropic conductive adhesive of the present invention applied to the gap between connection terminals 22 on the substrate 21 and connection bumps 26 formed on an n electrode 24 and a p electrode 25 of the LED element 23. In the cured product 100 of the light-reflective anisotropic conductive adhesive, the light-reflective conductive particles 10, the light-reflective needle-shaped insulating particles, and the light-reflective spherical insulating particles are dispersed in the cured product 11 of the thermosetting resin composition. If necessary, the light-emitting device may be sealed with a transparent molding resin such that the entire LED element 23 is covered therewith. A light reflecting layer may be provided in the LED element 23, as in a conventional device.

In the light-emitting device 200 configured as above, light emitted from the LED element 23 and directed toward the substrate 21 is reflected by the light-reflective conductive particles 10 in the cured product 100 of the light-reflective anisotropic conductive adhesive and then emitted from the upper surface of the LED element 23. Therefore, a reduction in light emission efficiency can be prevented. Since the light-reflective needle-shaped insulating particles are contained, the conduction reliability of the cured product of the light-reflective anisotropic conductive adhesive can be improved, and the occurrence of cracks can be suppressed or improved.

The configuration of the light-emitting device 200 of the present invention except for the light-reflective anisotropic conductive adhesive (i.e., the configuration of the LED element 23, the bumps 26, the substrate 21, the connection terminals 22, and the like) may be the same as the configuration of a conventional light-emitting device. The light-emitting device 200 of the present invention can be produced using a conventional anisotropic conductive connection technique except that the light-reflective anisotropic conductive adhesive of the present invention is used. Any well-known light-emitting element other than an LED element can also be used, so long as the effects of the present invention are not impaired.

### Examples

Specific examples of the present invention will next be described. However, the scope of the present invention is not limited to any of the following Examples.

### Examples 1 to 7 and Comparative Examples 1 to 4

### (Production of anisotropic conductive adhesives)

Light-reflective white needle-shaped insulating particles (metal oxide whiskers) and/or light-reflective white spherical insulating particles (metal oxide particles) in amounts shown in Table 1 and 10 parts by mass of gold-coated resin particles (average diameter: 5 µm) having a gold plating layer formed on the surfaces of spherical acrylic resin particles or light-reflective conductive particles (average diameter: 5 µm) coated with titanium oxide fine particles were mixed with a transparent epoxy-based thermosetting resin composition (refractive index: 1.45) containing 50 parts by mass of an alicyclic epoxy compound (CEL2021P, Daicel Corporation) and 50 parts by mass of methylhexahydrophthalic anhydride to prepare anisotropic conductive adhesives.

The light-reflective conductive particles used in Example 6 were produced as follows. A mechano-fusion apparatus (AMS-GMP, Hosokawa Micron Corporation) was charged with 4 parts by mass of titanium oxide powder with a particle diameter of 0.5 µm, 3 parts by mass of polystyrene-based powder with a particle diameter of 0.2 µm, and 20 parts by mass of particles with a diameter of 5 µm (20GNR4.6EH, NIPPON CHEMICAL INDUSTRIAL Co., Ltd., prepared by electroless gold plating of spherical acrylic resin particles having an average diameter of 4.6 µm with 0.2 µm thick gold). A light reflecting layer having a thickness of about 1 µm and composed of the titanium oxide particles was thereby formed on the surfaces of the gold-coated resin particles. The color of the appearance of the light-reflective conductive particles was gray.

The light-reflective white spherical insulating particles used in Examples 1 and 2 were prepared by coating the surfaces of TiO₂ particles having a diameter of 0.5 µm with a Si film and an Al film. The light-reflective white needle-shaped insulating particles used in Example 6 (Pana-Tetra®, AMTEC Co., Ltd.) were prepared by subjecting the surface of ZnO whiskers to surface treatment using a silicon coupling agent (silica treatment).

### (Evaluation of light reflectivity)

One of the produced anisotropic conductive adhesives was applied to a white plate to a thickness of 100 µm and cured by heating at 200°C for 1 minute. Then the total reflectivity (mirror reflection and diffuse reflection) of the obtained cured product for light of a wavelength of 450 nm was measured using a spectrophotometer (UV3100, Shimadzu Corporation) with barium sulfate as a standard. The results obtained are shown in Table 1. Practically, it is desirable that the light reflectivity be 30% or higher.

### (Production of LED-mounted module samples)

Gold (Au) bumps with a height of 15 µm were formed on a glass epoxy substrate having 100 µm-pitch copper traces plated with Ni/Au (5.0 µm thick/0.3 µm thick) using a bump holder (FB700, KAIJO corporation). A blue LED (Vf = 3.2 V (If = 20 mA)) was flip-chip mounted on the epoxy substrate with the gold bumps using one of the light-reflective anisotropic conductive adhesives under the conditions of 200°C, 20 seconds, and 1 kg/chip to obtain a test LED module.

### (Evaluation of total luminous flux)

The total luminous flux from each of the obtained test LED modules was measured using a total luminous flux measurement system (sphere type) (LE-2100, Otsuka Electronics Co., Ltd.) (measurement condition: If = 20 mA (constant current control)). The results obtained are shown in Table 1. Practically, it is desirable that the total luminous flux be 300 mlm or higher.

### (Evaluation of conduction reliability and crack resistance)

Conduction reliability and crack resistance were evaluated by the following two types of thermal cycle tests (TCT).

### <TCT-A>

A test LED module was exposed to an atmosphere of-40°C for 30 minutes and an atmosphere of 100°C for 30 minutes which is assumed as one thermal cycle, and this thermal cycle was repeated 1,000 times.

### <TCT-B>

A test LED module was exposed to an atmosphere of-55°C for 30 minutes and an atmosphere of 125°C for 30 minutes which is assumed as one thermal cycle, and this thermal cycle was repeated 1,000 times.

The conduction reliability of a test LED module removed after 1,000 TCT cycles was evaluated by measuring a Vf value at If = 20 mA. More specifically, the conduction reliability was evaluated according to the following criteria.

### Rank: Criterion

A: An increase in Vf value from the initial Vf value was less than 3%.
B: An increase in Vf value from the initial Vf value was 3% or larger and less than 5%.
C: An increase in Vf value from the initial Vf value was 5% or larger.

The occurrence of cracks in a test LED module removed after 1,000 TCT cycles was evaluated by observing the blue LED element through its upper surface under a metallurgical microscope to determine whether or not cracks had occurred in the cured product of the light-reflective anisotropic conductive adhesive. The results were evaluated according to the following criteria.

Rank: Criterion
A: No occurrence of cracks was observed.
B: The occurrence of a small number of cracks was observed, but the degree of the occurrence was practically acceptable.
C: The occurrence of cracks was observed.

**[Table 1]**

| | | | Example | | | | | | | Comparative Example | | | |
|---|---|---|---|---|---|---|---|---|---|---|---|---|---|
| | | | 1 | 2 | 3 | 4 | 5 | 6 | 7 | 1 | 2 | 3 | 4 |
| Conductive Partides | | Type of Plating | Au | Au | Au | Au | Au | Au | TiO₂/Au | Au | Au | Au | Au |
| Light-Reflective White Needle-Shaped Insulating Particles | | Type | TiO₂ | ZnO | ZnO | ZnO | ZnO | Silane-treated ZnO | ZnO | - | ZnO | - | ZnO |
| | | Fiber Length (µm) | 1.7 | 50 | 50 | 50 | 50 | 50 | 50 | - | 50 | - | 50 |
| | | Fiber Diameter (µm) | 0.13 | 3 | 3 | 3 | 3 | 3 | 3 | - | 3 | - | 3 |
| | | Aspect Ratio | 13.1 | 16.7 | 16.7 | 16.7 | 16.7 | 16.7 | 16.7 | - | 16.7 | - | 16.7 |
| | | AmountAdded (% by volume) | 8 | 8 | 8 | 8 | 8 | 8 | 8 | 0 | 12 | 0 | 8 |
| Light-Reflective White Spherical Insulating Particles | | Type | Si-and Al-coated TiO₂ | Si-and Al-coated TiO₂ | ZnO | ZnO | ZnO | ZnO | ZnO | - | - | ZnO | ZnO |
| | | Particle Diameter (pm) | 0.5 | 0.5 | 0.5 | 0.5 | 0.5 | 0.5 | 0.5 | - | - | 0.5 | 0.5 |
| | | Refractive Index | 2.71 | 2.71 | 1.95 | 1.95 | 1.95 | 1.95 | 1.95 | - | - | 1.95 | 1.95 |
| | | AmountAdded (% by volume) | 4 | 4 | 4 | 1 | 8 | 4 | 4 | 0 | 0 | 12 | 16 |
| Color of Anisotropic Conductive Adhesive | | | White | White | White | White | White | White | Whine | Brown | White | White | White |
| Total Reflectivity with respect to Light of Wavelength of 450 nm | | | 65 | 55 | 42 | 37 | 50 | 42 | 55 | 8 | 35 | 50 | 55 |
| Total Luminous Flux | (mim) | | 440 | 420 | 360 | 340 | 400 | 360 | 420 | 200 | 300 | 350 | 420 |
| Crack Resistance | TCT-A | | A | A | A | A | A | A | A | A | A | C | B |
| | TCT-B | | A | A | A | A | A | A | A | A | A | C | C |
| Conduction Reliability | Initial | | A | A | A | A | A | A | A | A | A | A | A |
| | TCT-A | | A | A | A | A | A | A | A | A | A | A | A |
| | TCT-B | | A | A | A | A | A | A | A | A | A | B | B |

As can be seen from Table 1, in the anisotropic conductive adhesives in Examples 1 to 7, the total reflectivity was 37% or higher, and the total luminous flux was 340 mlm or higher. In addition, the results of the crack resistance evaluation and the conduction reliability evaluation were "A".

On the other hand, in the anisotropic conductive adhesive in Comparative Example 1, since no light-reflective insulating particles were added, the appearance of the anisotropic conductive adhesive was brown. Therefore, the total reflectivity was very low or 8%, and the total luminous flux was also very low or 200 mlm.

In the anisotropic conductive adhesive in Comparative Example 2, the total amount of the light-reflective insulating particles added was the same as that in the anisotropic conductive adhesive in Example 3. However, no light-reflective white spherical insulating particles were added, and only light-reflective white needle-shaped insulating particles were used. Therefore, the total reflectivity was reduced from 42% (Example 3) to 35%, and the total luminous flux was reduced from 360 mlm (Example 3) to 300 mlm.

In the anisotropic conductive adhesive in Comparative Example 3, the total amount of the light-reflective insulating particles added was the same as that in the anisotropic conductive adhesive in Example 3. However, no light-reflective white needle-shaped insulating particles were added, and only light-reflective white spherical insulating particles were used. Although the total reflectivity was improved from 42% (Example 3) to 50%, the result of the crack resistance evaluation was "C", and the result of the conduction reliability evaluation was "B" in the case of TCT-B.

In the anisotropic conductive adhesive in Comparative Example 4, the amount of light-reflective white spherical insulating particles was increased from 4 vol%, which is the amount used in the anisotropic conductive adhesive in Example 3, to 16 vol%. Therefore, the total reflectivity and the total luminous flux were improved. However, the result of the crack resistance evaluation was "B" or "C", and the result of the conduction reliability evaluation was "B" (TCT-B).

### Industrial Applicability

In the light-reflective anisotropic conductive adhesive of the present invention, light-reflective needle-shaped insulating particles in an amount of 1 to 50 percent by volume and light-reflective spherical insulating particles in an amount of 1 to 50 percent by volume are added to a thermosetting resin composition, and the mixing ratio of the light-reflective spherical insulating particles to the light-reflective needle-shaped insulating particles is set to 1:1 to 10. Therefore, light emission efficiency can be improved without providing, on the LED element, a light reflecting layer that causes an increase in production cost. In addition, a reduction in conduction reliability and the occurrence of cracks in the anisotropic conductive connection portion of the light-emitting device when the temperature of the surroundings thereof changes can be suppressed or prevented. Therefore, the light-reflective anisotropic conductive adhesive of the present invention is useful for flip-chip mounting of an LED element.

### Reference Signs List

1 core particle
2 inorganic particle
3, 40 light reflecting layer
4 thermoplastic resin
10, 20 light-reflective conductive particle
11 cured product of thermosetting resin composition
21, 31 substrate
22, 36 connection terminal
23, 33 LED element
24, 35 n electrode
25, 34 p electrode
26, 39 bump
32 die-bonding adhesive
37 gold wire
38 transparent molding resin
41 anisotropic conductive paste (ACP)
100 cured product of light-reflective anisotropic
conductive adhesive
200 light-emitting device

## Claims

1. A light-reflective anisotropic conductive adhesive that is used for anisotropic conductive connection of a light-emitting element to a wiring board, the light-reflective anisotropic conductive adhesive comprising a thermosetting resin composition, a conductive particle, a light-reflective needle-shaped insulating particle, and a light-reflective spherical insulating particle, wherein
each of an amount of the light-reflective needle-shaped insulating particle and an amount of the light-reflective spherical insulating particle is 1 to 50 percent by volume based on a volume of the thermosetting resin composition, and a mixing ratio (V/V) of the light-reflective spherical insulating particle to the light-reflective needle-shaped insulating particle is 1:1 to 10.

2. The light-reflective anisotropic conductive adhesive according to claim 1, wherein the light-reflective needle-shaped insulating particle is at least one type of needle-shaped inorganic particle selected from the group consisting of a titanium oxide whisker, a zinc oxide whisker, a titanate whisker, an aluminum borate whisker, and wollastonite.

3. The light-reflective anisotropic conductive adhesive according to claim 2, wherein the light-reflective needle-shaped insulating particle is a zinc oxide whisker.

4. The light-reflective anisotropic conductive adhesive according to any of claims 1 to 3, wherein the light-reflective needle-shaped insulating particle is a needle-shaped inorganic particle treated with a silane coupling agent.

5. The light-reflective anisotropic conductive adhesive according to any of claims 1 to 4, wherein an aspect ratio of the light-reflective needle-shaped insulating particle is larger than 10 and less than 35.

6. The light-reflective anisotropic conductive adhesive according to any of claims 1 to 5, wherein a refractive index (JIS K7142) of the light-reflective needle-shaped insulating particle is larger than a refractive index (JIS K7142) of a cured product of the thermosetting resin composition.

7. The light-reflective anisotropic conductive adhesive according to any of claims 1 to 6, wherein the light-reflective spherical insulating particle is at least one type of spherical inorganic particle selected from the group consisting of titanium oxide, boron nitride, zinc oxide, and aluminum oxide.

8. The light-reflective anisotropic conductive adhesive according to claim 7, wherein an average diameter of the light-reflective spherical insulating particle is 0.02 to 20 µm.

9. The light-reflective anisotropic conductive adhesive according to any of claims 1 to 7, wherein a refractive index (JIS K7142) of the light-reflective spherical insulating particle is larger than a refractive index (JIS K7142) of a cured product of the thermosetting resin composition.

10. The light-reflective anisotropic conductive adhesive according to any of claims 1 to 6, wherein the light-reflective spherical insulating particle is a resin-coated metal particle obtained by coating a surface of a spherical metal particle with an insulating resin.

11. The light-reflective anisotropic conductive adhesive according to claim 10, wherein the light-reflective spherical insulating particle is a resin-coated silver particle obtained by coating a surface of a spherical silver particle with an insulating resin.

12. The light-reflective anisotropic conductive adhesive according to any of claims 1 to 11, wherein the thermosetting resin composition contains an epoxy resin and an acid anhydride-based curing agent.

13. The light-reflective anisotropic conductive adhesive according to any of claims 1 to 12, wherein the conductive particle is a light-reflective conductive particle including a core particle coated with a metal material and a light reflecting layer disposed on a surface of the core particle and formed of at least one type of inorganic particle selected from a titanium oxide particle, a zinc oxide particle, and an aluminum oxide particle.

14. The light-reflective anisotropic conductive adhesive according to any of claims 1 to 13, wherein an amount added of the light-reflective conductive particle is 1 to 100 parts by mass based on 100 parts by mass of the thermosetting resin composition.

15. A light-emitting device in which a light-emitting element is flip-chip mounted on a wiring board through the light-reflective anisotropic conductive adhesive according to any of claims 1 to 14.

16. The light-emitting device according to claim 15, wherein the light-emitting element is a light emitting diode.

## Patentansprüche

1. Lichtreflektierendes, anisotrop leitfähiges Haftmittel, das für eine anisotrop leitfähige Verbindung eines lichtemittierenden Elements mit einer Verdrahtungsplatte verwendet wird, wobei das lichtreflektierende, anisotrop leitfähige Haftmittel eine Duroplastharzzusammensetzung, ein leitfähiges Teilchen, ein lichtreflektierendes, nadelförmiges isolierendes Teilchen und ein lichtreflektierendes, kugelförmiges isolierendes Teilchen umfasst, wobei jeweils ein Anteil des lichtreflektierenden, nadelförmigen isolierenden Teilchens und ein Anteil des lichtreflektierenden, kugelförmigen isolierenden Teilchens 1 bis 50 Volumenprozent, basierend auf einem Volumen der Duroplastharzzusammensetzung, und ein Mischungsverhältnis (V/V) des lichtreflektierenden, kugelförmigen isolierenden Teilchens zu dem lichtreflektierenden, nadelförmigen isolierenden Teilchen 1:1 bis 10, beträgt.

2. Lichtreflektierendes, anisotrop leitfähiges Haftmittel nach Anspruch 1, wobei das lichtreflektierende, nadelförmige isolierende Teilchen mindestens eine Art nadelförmiges anorganisches Teilchen, ausgewählt aus der Gruppe, bestehend aus einem Titanoxid-Whisker, einem Zinkoxid-Whisker, einem Titanat-Whisker, einem Aluminiumborat-Whisker und Wollastonit, ist.

3. Lichtreflektierendes, anisotrop leitfähiges Haftmittel nach Anspruch 2, wobei das lichtreflektierende, nadelförmige isolierende Teilchen ein Zinkoxid-Whisker ist.

4. Lichtreflektierendes, anisotrop leitfähiges Haftmittel nach einem der Ansprüche 1 bis 3, wobei das lichtreflektierende, nadelförmige isolierende Teilchen ein mit einem Silanhaftvermittler behandeltes nadelförmiges anorganisches Teilchen ist.

5. Lichtreflektierendes, anisotrop leitfähiges Haftmittel nach einem der Ansprüche 1 bis 4, wobei ein Seitenverhältnis des lichtreflektierenden, nadelförmigen isolierenden Teilchens größer als 10 und geringer als 35 ist.

6. Lichtreflektierendes, anisotrop leitfähiges Haftmittel nach einem der Ansprüche 1 bis 5, wobei ein Brechungsindex (JIS K7142) des lichtreflektierenden, nadelförmigen isolierenden Teilchens größer als ein Brechungsindex (JIS K7142) eines ausgehärteten Produkts der Duroplastharzzusammensetzung ist.

7. Lichtreflektierendes, anisotrop leitfähiges Haftmittel nach einem der Ansprüche 1 bis 6, wobei das lichtreflektierende, kugelförmige isolierende Teilchen mindestens eine Art kugelförmiges anorganisches Teilchen, ausgewählt aus der Gruppe, bestehend aus Titanoxid, Bornitrid, Zinkoxid und Aluminiumoxid, ist.

8. Lichtreflektierendes, anisotrop leitfähiges Haftmittel nach Anspruch 7, wobei ein mittlerer Durchmesser des lichtreflektierenden, kugelförmigen isolierenden Teilchens 0,02 bis 20 µm beträgt.

9. Lichtreflektierendes, anisotrop leitfähiges Haftmittel nach einem der Ansprüche 1 bis 7, wobei ein Brechungsindex (JIS K7142) des lichtreflektierenden, kugelförmigen isolierenden Teilchens größer als ein Brechungsindex (JIS K7142) eines ausgehärteten Produkts der Duroplastharzzusammensetzung ist.

10. Lichtreflektierendes, anisotrop leitfähiges Haftmittel nach einem der Ansprüche 1 bis 6, wobei das lichtreflektierende, kugelförmige isolierende Teilchen ein mit Harz beschichtetes Metallteilchen, erhalten durch Beschichten einer Oberfläche eines kugelförmigen Metallteilchens mit einem isolierenden Harz, ist.

11. Lichtreflektierendes, anisotrop leitfähiges Haftmittel nach Anspruch 10, wobei das lichtreflektierende, kugelförmige isolierende Teilchen ein mit Harz beschichtetes Silberteilchen, erhalten durch Beschichten einer Oberfläche eines kugelförmigen Silberteilchens mit einem isolierenden Harz, ist.

12. Lichtreflektierendes, anisotrop leitfähiges Haftmittel nach einem der Ansprüche 1 bis 11, wobei die Duroplastharzzusammensetzung ein Epoxidharz und ein Säureanhydrid-basiertes Aushärtungsmittel enthält.

13. Lichtreflektierendes, anisotrop leitfähiges Haftmittel nach einem der Ansprüche 1 bis 12, wobei das leitfähige Teilchen ein lichtreflektierendes, leitfähiges Teilchen, enthaltend ein mit einem Metallmaterial beschichtetes Kernteilchen und eine lichtreflektierende Schicht, abgeschieden auf einer Oberfläche des Kernteilchens und gebildet aus mindestens einer Art eines anorganischen Teilchens, ausgewählt aus einem Titanoxidteilchen, einem Zinkoxidteilchen und einem Aluminiumoxidteilchen, ist.

14. Lichtreflektierendes, anisotrop leitfähiges Haftmittel nach einem der Ansprüche 1 bis 13, wobei ein hinzugefügter Anteil des lichtreflektierenden, leitfähigen Teilchens 1 bis 100 Massenanteile, basierend auf 100 Massenanteilen der Duroplastharzzusammensetzung, beträgt.

15. Lichtemittierende Vorrichtung, in der ein lichtemittierendes Element auf eine Verdrahtungsplatte durch das lichtreflektierende, anisotrop leitfähige Haftmittel nach einem der Ansprüche 1 bis 14 flip-chip-montiert ist.

16. Lichtemittierende Vorrichtung nach Anspruch 15, wobei das lichtemittierende Element eine lichtemittierende Diode ist.

## Revendications

1. Adhésif conducteur anisotrope réfléchissant la lumière qui est utilisé afin d'assurer une liaison conductrice anisotrope d'un élément émetteur de lumière avec une carte de circuit imprimé, l'adhésif conducteur anisotrope réfléchissant la lumière comprenant une composition de résine thermodurcissable, des particules conductrices, des particules isolantes en forme d'aiguille réfléchissant la lumière, et des particules isolantes sphériques réfléchissant la lumière, dans lequel
chacune d'une quantité de particules isolantes en forme d'aiguille réfléchissant la lumière et d'une quantité de particules isolantes sphériques réfléchissant la lumière est comprise entre 1 et 50 pourcent en volume sur la base d'un volume de la composition de résine thermodurcissable, et un rapport de mélange (V/V) des particules isolantes sphériques réfléchissant la lumière sur les particules isolantes en forme d'aiguille réfléchissant la lumière est compris dans la plage de 1:1 à 10.

2. Adhésif conducteur anisotrope réfléchissant la lumière selon la revendication 1, dans lequel les particules isolantes en forme d'aiguille réfléchissant la lumière sont d'au moins un type de particules non organiques en forme d'aiguille sélectionné à partir du groupe constitué par des barbes d'oxyde de titane, des barbes d'oxyde de zinc, des barbes de titanate, des barbes de borate d'aluminium et de la wollastonite.

3. Adhésif conducteur anisotrope réfléchissant la lumière selon la revendication 2, dans lequel les particules isolantes en forme d'aiguille réfléchissant la lumière sont des barbes d'oxyde de zinc.

4. Adhésif conducteur anisotrope réfléchissant la lumière selon l'une quelconque des revendications 1 à 3, dans lequel les particules isolantes en forme d'aiguille réfléchissant la lumière sont des particules non organiques en forme d'aiguille traitées avec un agent de couplage à base de silane.

5. Adhésif conducteur anisotrope réfléchissant la lumière selon l'une quelconque des revendications 1 à 4, dans lequel un rapport d'allongement des particules isolantes en forme d'aiguille réfléchissant la lumière est supérieur à 10 et inférieur à 35.

6. Adhésif conducteur anisotrope réfléchissant la lumière selon l'une quelconque des revendications 1 à 5, dans lequel un indice de réfraction (JIS K7142) des particules isolantes en forme d'aiguille réfléchissant la lumière est supérieur à un indice de réfraction (JIS K7142) d'un produit durci à base de la composition de résine thermodurcissable.

7. Adhésif conducteur anisotrope réfléchissant la lumière selon l'une quelconque des revendications 1 à 6, dans lequel les particules isolantes sphériques réfléchissant la lumière sont au moins d'un type de particules non organiques sphériques sélectionné à partir du groupe constitué par l'oxyde de titane, le nitrure de bore, l'oxyde de zinc et l'oxyde d'aluminium.

8. Adhésif conducteur anisotrope réfléchissant la lumière selon la revendication 7, dans lequel un diamètre moyen des particules isolantes sphériques réfléchissant la lumière est compris entre 0,02 et 20 µm.

9. Adhésif conducteur anisotrope réfléchissant la lumière selon l'une quelconque des revendications 1 à 7, dans lequel un indice de réfraction (JIS K7142) des particules isolantes sphériques réfléchissant la lumière est supérieur à un indice de réfraction (JIS K7142) d'un produit à base de la composition de résine thermodurcissable durcie.

10. Adhésif conducteur anisotrope réfléchissant la lumière selon l'une quelconque des revendications 1 à 6, dans lequel les particules isolantes sphériques réfléchissant la lumière sont des particules métalliques revêtues de résine obtenues par revêtement d'une surface de particules métalliques sphériques avec une résine isolante.

11. Adhésif conducteur anisotrope réfléchissant la lumière selon la revendication 10, dans lequel les particules isolantes sphériques réfléchissant la lumière sont des particules d'argent revêtues de résine obtenues par revêtement d'une surface de particules sphériques d'argent avec une résine isolante.

12. Adhésif conducteur anisotrope réfléchissant la lumière selon l'une quelconque des revendications 1 à 11, dans lequel la composition de résine thermodurcissable contient une résine époxy et un agent durcisseur à base d'anhydride d'acide.

13. Adhésif conducteur anisotrope réfléchissant la lumière selon l'une quelconque des revendications 1 à 12, dans lequel les particules conductrices sont des particules conductrices réfléchissant la lumière comportant des particules formant noyau revêtues d'un matériau métallique et une couche réfléchissant la lumière disposée sur une surface des particules formant noyau et formées d'au moins un type de particules non organiques sélectionné à partir de particules d'oxyde de titane, de particules d'oxyde de zinc et de particules d'oxyde d'aluminium.

14. Adhésif conducteur anisotrope réfléchissant la lumière selon l'une quelconque des revendications 1 à 13, dans lequel une quantité ajoutée des particules conductrices réfléchissant la lumière est comprise entre 1 et 100 parties en masse sur la base de 100 parties en masse de la composition de résine thermodurcissable.

15. Dispositif émetteur de lumière dans lequel un élément émetteur de lumière présente un montage en pastille retournée (flip-chip) sur un circuit imprimé par l'intermédiaire d'un adhésif conducteur anisotrope réfléchissant la lumière selon l'une quelconque des revendications 1 à 14.

16. Dispositif émetteur de lumière selon la revendication 15, dans lequel l'élément émetteur de lumière est une diode émettrice de lumière.
